(19) Europäisches Patentamt

European Patent Office

Office européen des brevets

(11) **EP 1 116 957 B1**

(12) **EUROPÄISCHE PATENTSCHRIFT**

(45) Veröffentlichungstag und Bekanntmachung des Hinweises auf die Patenterteilung:
**11.10.2006 Patentblatt 2006/41**

(21) Anmeldenummer: **00127824.1**

(22) Anmeldetag: **19.12.2000**

(51) Int Cl.:
***G01R 31/26*** (2006.01)

(54) **Schaltungsanordnung zur Kapazitätsmessung von Strukturen in einer integrierten Schaltung**

Capacity measurement of structures in integrated circuits

Mesure de la capacité des structures dans un circuit intégré

(84) Benannte Vertragsstaaten:
**DE GB IE**

(30) Priorität: **13.01.2000 DE 10001129**

(43) Veröffentlichungstag der Anmeldung:
**18.07.2001 Patentblatt 2001/29**

(73) Patentinhaber: **Qimonda AG**
**81739 München (DE)**

(72) Erfinder:
• **Lindolf, Jürgen**
**86316 Friedberg (DE)**
• **Schatt, Stefanie**
**93047 Regensburg (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**FR-A- 2 780 162**

• **SYLVESTER D ET AL: "INVESTIGATION OF INTERCONNECT CAPACITANCE CHARACTIZATION USING CHARGE-BASED CAPACITANCE MEASUREMENT (CBCM) TECHNIQUE AND THREE- DIMENSIONAL SIMULATION" IEEE JOURNAL OF SOLID-STATE CIRCUITS, IEEE INC. NEW YORK, US, Bd. 33, Nr. 3, März 1998 (1998-03), Seiten 449-453, XP000774526 ISSN: 0018-9200**
• **CHEN J C ET AL: "An on-chip, attofarad interconnect charge-based capacitance measurement (CBCM) technique" ELECTRON DEVICES MEETING, 1996., INTERNATIONAL SAN FRANCISCO, CA, USA 8-11 DEC. 1996, NEW YORK, NY, USA,IEEE, US, 8. Dezember 1996 (1996-12-08), Seiten 69-72, XP010207538 ISBN: 0-7803-3393-4**

## Beschreibung

Die vorliegende Erfindung betrifft eine Schaltungsanordnung zur Kapazitätsmessung von Strukturen in einer integrierten Schaltung nach dem Oberbegriff des Patentanspruchs 1.

Integrierte Schaltungen weisen einen strukturellen, topographischen Aufbau auf, der im allgemeinen schichtartig angeordnet ist. Beispielsweise weist die integrierte Schaltung Transistoren und Metalleiterbahnen auf, die schichtartig nebeneinander oder übereinander auf einem Halbleitersubstrat aufgebracht sind. Moderne integrierte Halbleiterschaltungen weisen meist immer kleinere Strukturgrößen auf und werden mit zunehmend steigenden Taktraten betrieben. Mit zunehmenden Übertragungsraten nimmt im allgemeinen der Einfluss von Kapazitäten auf die Signalgeschwindigkeit zu. Solche Kapazitäten können beispielsweise auftreten zwischen den Schichten von Metalleiterbahnen und/oder Kontaktierungsgebieten von Transistoren. Im Zuge der Fortentwicklung einer integrierten Schaltung ist es daher Ziel, verschiedene Arten von Kapazitäten zu bestimmen und in gewünschter Weise zu beeinflussen.

Kapazitäten werden beispielsweise anhand von großen Teststrukturen ermittelt. Weiterhin können Kapazitäten in integrierten Schaltungen bestimmt werden durch die sogenannte "Charge-Based Capacitance Measurement (CBCM) Technik. Diese Technik ist beispielsweise beschrieben in "Investigation of Interconnect Capacitance Characterization Using Charge-Based Capacitance Measurement (CBCM) Technique and Three-Dimensional Simulation", D. Sylvester, J. C. Chen, C. Hu, IEEE J. Solid State Circuits, 33 (1998). Die dort beschriebene Methode wird insbesondere angewandt zur Bestimmung von unterschiedlichen Arten von Kapazitäten an Metalleiterbahnen in einer integrierten Schaltung. Es wird weiterhin eine Meßschaltung vorgestellt, mit zwei Transistor-Serienschaltungen, die jeweils an einer Teststruktur beziehungsweise Referenzstruktur angeschlossen sind. Mit dieser Schaltung können vorteilhaft insbesondere verhältnismäßig kleine Strukturen beziehungsweise kleine Kapazitäten in integrierten Schaltungen bestimmt werden, da durch Einbeziehung einer Referenzstruktur insbesondere parasitäre Kapazitäten beispielsweise an Zuleitungen kompensiert werden. Sie umgeht dabei das meßtechnische Problem, daß in Folge immer kleinerer Werte der zu messenden Kapazitäten eine entsprechende Kalibrierung von Meßgeräten meist nicht mehr ausreicht, um Meßfehler zu beseitigen.

Die Funktion der beschriebenen Schaltung besteht insbesondere darin, daß die mit einer bestimmten Kapazität behaftete Teststruktur und die dazu in Bezug gesetzte Referenzstruktur jeweils zwischen zwei Potentialen umgeladen werden. Dabei werden jeweils die durchschnittlichen Umladeströme gemessen und mit deren Differenz die zu bestimmende Kapazität ermittelt.

An den kontaktierten Gebieten eines Transistors in einer integrierten Schaltung treten im allgemeinen unterschiedliche Arten von Kapazitäten auf. Dies können beispielsweise die sogenannte Junction-Kapazität, der Kapazität zwischen den Source-/Drain-Gebieten und dem Substrat, die sogenannte Dünnschichtkapazität, der Kapazität zwischen dem Gate-Gebiet und dem Substrat, und die sogenannte Überlapp-Kapazität, der Kapazität zwischen dem Gate-Gebiet und den jeweiligen Source-/Drain-Gebieten, sein. Diese Kapazitäten sind im allgemeinen abhängig von dem jeweils anliegenden Potentialwert. Das heißt, diese Kapazitäten sind spannungsabhängig und daher in einer spannungsabhängigen, differenziellen Kapazitätsmessung zu bestimmen. Da in der beschriebenen Schaltung die Kapazitäten zwischen einem festen Bezugspotential der integrierten Schaltung und einem positiven Potential umgeladen werden, ist eine spannungsabhängige Kapazitätsmessung nur eingeschränkt möglich.

Die Aufgabe der vorliegenden Erfindung ist es, eine Schaltungsanordnung zur Kapazitätsmessung von Strukturen in einer integrierten Schaltung nach der eingangs genannten Art anzugeben, mit der eine spannungsabhängige, differenzielle Kapazitätsmessung möglich ist.

Die Aufgabe wird gelöst durch eine Schaltungsanordnung zur Kapazitätsmessung von Strukturen in einer integrierten Schaltung nach dem kennzeichnenden Teil des Patentanspruchs 1. Vorteilhafte Aus- und Weiterbildungen sind in Unteransprüchen gekennzeichnet.

Die Referenzstruktur weist einen zur Teststruktur im wesentlichen ähnlichen Aufbau auf. Der Aufbau kann schichtartig sein, beispielsweise bei der Messung von Kapazitäten an den Anschlüssen eines schichtartig angeordneten Transistors. Es ist auch möglich, sogenannte laterale Wire-Wire-Kapazitäten der Teststruktur zu messen, mit einer entsprechend ähnlich aufgebauten Referenzstruktur, die in dem Fall nur das für die Messung wesentliche sogenannte Wiring beinhaltet.

Die Schaltungsanordnung umfaßt eine erste und zweite Serienschaltung, die jeweils zwei Transistoren umfaßt, die mit ihren gesteuerten Strecken in Reihe geschaltet sind, und die parallel zwischen Versorgungsanschlüssen für jeweils ein Versorgungspotential geschaltet sind. Ein Anschluß für die Teststruktur ist an den Kopplungsknoten der Transistoren der ersten Serienschaltung angeschlossen, ein Anschluß für die Referenzstruktur ist an den Kopplungsknoten der Transistoren der zweiten Serienschaltung angeschlossen. Indem die Versorgungsanschlüsse der beiden Serienschaltungen mit einer steuerbaren Spannungsquelle verbunden sind, kann eine spannungsabhängige, differenzielle Kapazitätsmessung durchgeführt werden.

Beispielsweise werden die Versorgungsspannungen über die Spannungsquelle derart eingestellt, daß sich ein relativer Potentialunterschied von zum Beispiel 0,1 V ergibt. Das Niveau der Versorgungsspannungen kann zwischen den Messungen in diskreten Schritten verändert werden. Es stellen sich so unterschiedliche Arbeitspunkte an den zu messenden Kapazitäten ein, wodurch eine differenzielle Kapazitätsmessung durchgeführt werden kann.

In der eingangs beschriebenen Schaltung werden zum Aufladen der Teststruktur beziehungsweise Referenzstruktur jeweils PMOS-Transistoren verwendet, zur Entladung der Test- beziehungsweise Referenzstruktur NMOS-Transistoren. Wenn die Versorgungsspannung sinkt, besteht die Gefahr, daß die anliegende Gatespannung über die Einsatzspannung des PMOS-Transistors steigt. Eine diesbezügliche Absenkung der Gatespannung hin zu negativen Werten ist zur Vermeidung von Potentialverschiebungen an der gesamten integrierten Schaltung meist nicht geeignet. Um eine vollständige Aufladung der Test- beziehungsweise Referenzstruktur auch bei Potentialwerten zu gewährleisten, die nahe dem Bezugspotential der integrierten Schaltung sind, sind bei der erfindungsgemäßen Schaltungsanordnung NMOS-Transistoren vorgesehen. Die Gate-Anschlüsse der jeweiligen NMOS-Transistoren sind durch ein positives Potential derart ansteuerbar, daß sich der jeweilige Transistor auch bei einem niedrigen Versorgungspotential im niederohmigen Bereich befindet.

Entsprechend weist die Schaltungsanordnung zur Einstellung von Arbeitspunkten mit negativem Potentialwert NMOS-Transistoren mit jeweils einer isolierten P-dotierten Wanne auf. Die isolierte Wanne, die sich in ebenfalls p-dotiertem Substrat befindet, wird dabei an einem entsprechenden negativen Potential angeschlossen.

Die Erfindung wird im folgenden anhand der in der Zeichnung dargestellten Figuren näher erläutert. Es zeigen:

Figur 1    eine Schaltungsanordnung zur Kapazitätsmessung von Strukturen in einer integrierten Schaltung,

Figur 2    eine erfindungsgemäße Schaltungsanordnung zur spannungsabhängigen differenziellen Kapazitätsmessung,

Figur 3    ein Signaldiagramm zu der Schaltungsanordnung nach Figur 2.

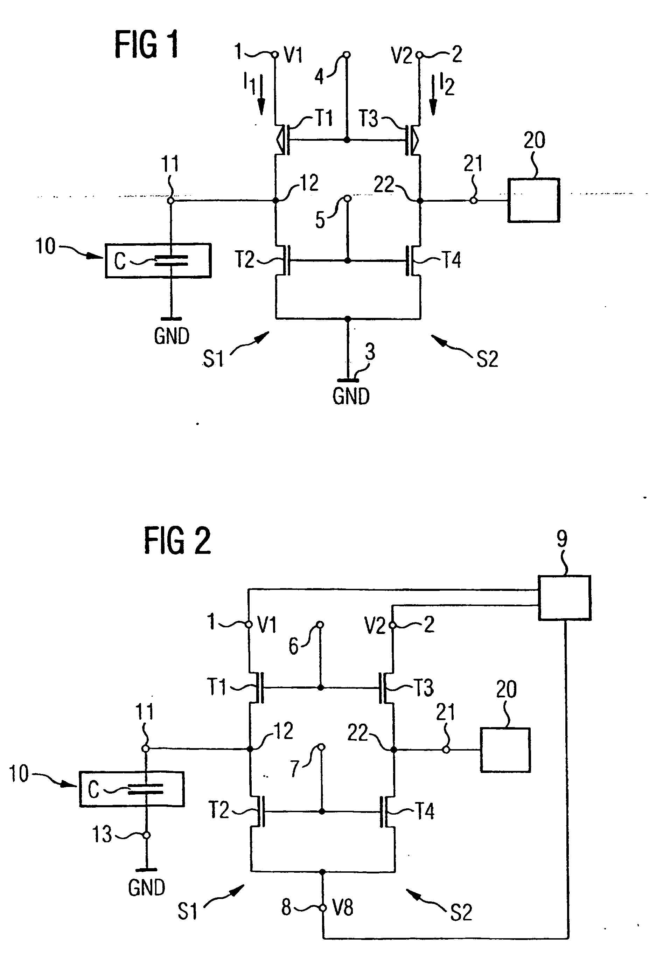

Figur 1 zeigt eine Schaltungsanordnung zur Kapazitätsmessung von Strukturen in einer integrierten Schaltung nach dem Stand der Technik. Die Schaltungsanordnung weist eine erste Serienschaltung S1 und eine zweite Serienschaltung S2 auf, die jeweils zwei Transistoren T1, T2 beziehungsweise T3, T4 umfassen, die mit ihren gesteuerten Strecken in Reihe geschaltet sind. Die Serienschaltungen S1 und S2 sind zwischen die Versorgungsanschlüsse 1 beziehungsweise 2 und 3 geschaltet. An den Versorgungsanschlüssen 1 und 2 liegt beispielsweise ein positives Versorgungspotential V1, V2 gleich VDD an, an dem Versorgungsanschluß 3 liegt beispielsweise ein festes Bezugspotential GND der integrierten Schaltung an. Ein Anschluß 11 für die Teststruktur 10 ist an den Kopplungsknoten 12 der Transistoren T1 und T2 der Serienschaltung S1 angeschlossen. Die Teststruktur 10 ist schematisch dargestellt durch die Kapazität C. Ein Anschluß 21 für die Referenzstruktur 20 ist an den Kopplungsknoten 22 der Transistoren T3 und T4 der Serienschaltung S2 angeschlossen.

Zur Messung der Kapazität C werden die Steueranschlüsse 4 und 5 der Transistoren entsprechend mit einander nicht überlappenden Signalen angesteuert. Durch die Ströme I1 und I2 werden die Teststruktur 10 und die Referenzstruktur 20 aufgeladen beziehungsweise entladen. Dabei ist durch eine entsprechende Ansteuerung der Anschlüsse 4 und 5 zu vermeiden, daß ein Kurzschlußstrom zwischen den in Reihe geschalteten Transistoren der jeweiligen Serienschaltung fließt. Die Differenz zwischen den zu messenden Strömen I1 und I2 ist direkt proportional zu der zu messenden Kapazität C. Die Kapazität C berechnet sich dabei nach der Formel

$$C \cdot VDD \cdot f = I1 - I2.$$

Die gemessenen Ströme I1 und I2 sind dabei jeweils gemessene Durchschnittswerte, f ist die Frequenz des Taktzyklus der Messung. Die bei der Messung erzielbare Auflösung ist dabei im wesentlichen abhängig von der Anordnung der beiden Serienschaltungen S1 und S2. Indem diese relativ klein dimensioniert werden und relativ nahe beieinander auf der integrierten Schaltung angeordnet werden, läßt sich der Einfluß von parasitären Kapazitäten auf das Meßergebnis signifikant reduzieren. Wie eingangs beschrieben, wird eine derartige Schaltungsanordnung vor allem zur Messung von Kapazitäten entlang von Metalleiterbahnen verwendet, die im allgemeinen nicht abhängig vom Niveau der an den Metalleiterbahnen anliegenden Spannung sind.

Figur 2 zeigt eine erfindungsgemäße Schaltungsanordnung zur spannungsabhängigen, differenziellen Kapazitätsmessung. Die Schaltungsanordnung weist einen weitgehend ähnlichen strukturellen Aufbau zu der in Figur 1 dargestellten Schaltunganordnung auf. Im Gegensatz zu der Schaltung nach Figur 1 liegen in Figur 2 die Versorgungsanschlüsse 1, 2 und 8, die mit der steuerbaren Spannungsquelle 9 verbunden sind, an steuerbaren Versorgungsspannungen V1, V2, V8 an. Ein weiterer Anschluß 13 der Teststruktur 10 ist weiterhin an dem festen Bezugspotential GND der integrierten Schaltung angeschlossen. An den Anschlüssen 1 beziehungsweise 2 liegt beispielsweise ein positives Versorgungspotential VDD an, an dem Anschluß 8 liegt beispielsweise ein dazu vermindertes Potential VSS an.

Gemäß dem Prinzip der in Figur 1 erläuterten Messung der Kapazität C ergibt sich an dem Anschluß 11 ein Arbeitspunkt

$$A = (VDD + VSS)/2$$

(Mittelwert aus VDD und VSS). VDD ist beispielsweise festgelegt zu VDD = VSS + 0,1V.

Die Schaltungsanordnung nach Figur 2 weist ferner, abweichend von der Schaltungsanordnung nach Figur 1, NMOS-Transistoren T1 und T3 auf. Um einen vollen Spannungshub bis VDD an der Kapazität C zu gewährleisten, werden die Gatespannungen der Transistoren T1 und T3 um etwa eine Einsatzspannung höher als VDD gesetzt. Für negative Arbeitspunkte der Kapazität C werden NMOS-Transistoren verwendet, die eine isolierte P-Wanne aufweisen.

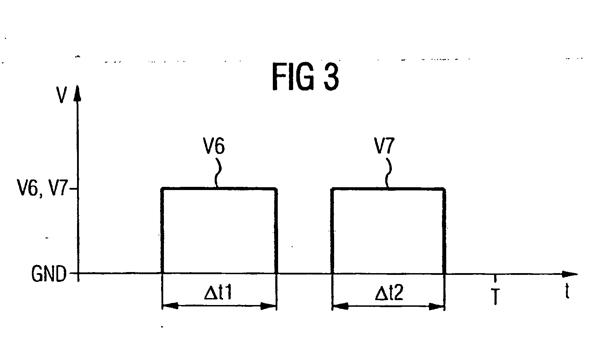

In Figur 3 ist ein Signaldiagramm für die Schaltungsanordnung nach Figur 2 gezeigt. An den Anschlüssen 6 und 7 werde jeweils für diskrete Zeitschritte Δt1 und Δt2 die Potentialwerte V6 und V7 angelegt. Zur Vermeidung eines Kurzschlußstroms zwischen den Transistoren T1 und T2 beziehungsweise T3 und T4 ist eine zeitliche Überlappung der an den Anschlüssen 6 und 7 anliegenden Potentiale V6 und V7 zu vermeiden. Ein typischer Taktzyklus während einer Messung beträgt beispielsweise die Zeit T = 2 μs. Entsprechend sind Δt1 und Δt2 beispielsweise mit je 900 ns bemessen. Für eine Spannung VDD = 2,3V betragen V6 und V7 beispielsweise 3,5V.

Die erfindungsgemäße Schaltungsanordnung ist vorteilhaft verwendbar zur Messung von NMOS-Junction-Kapazitäten sowie von NMOS-Überlappkapazitäten. Die Schaltung ist weiterhin vorteilhaft einsetzbar zur Messung von NMOS-Dünnschichtkapazitäten sowie spannungsabhängigen Kapazitäten entlang von Metalleiterbahnen.

**Patentansprüche**

1. Schaltungsanordnung zur Kapazitätsmessung von Strukturen in einer integrierten Schaltung, die integrierte Schaltung umfassend eine Teststruktur (10) und eine Referenzstruktur (20),

   - mit einem ersten, einem zweiten und einem dritten Versorgungsanschluss (1, 2, 8) für jeweils ein Versorgungspotential (V1, V2, V8),
   - mit einer ersten (S1) und zweiten Serienschaltung (S2), die jeweils zwei Transistoren (T1, T2; T3, T4) umfassen, die mit ihren gesteuerten Strecken in Reihe geschaltet sind, wobei die erste Serienschaltung (S1) zwischen den ersten und den dritten Versorgungsanschluss (1, 8) und die zweite Serienschaltung (S2) zwischen den zweiten und den dritten Versorgungsanschluss (2, 8) geschaltet ist,
   - bei der ein Anschluss (11) für die Teststruktur (10) an den Kopplungsknoten (12) der Transistoren (T1, T2) der ersten Serienschaltung (S1) angeschlossen ist,
   - bei der ein Anschluss (21) für die Referenzstruktur (20) an den Kopplungsknoten (22) der Transistoren (T3, T4) der zweiten Serienschaltung (S2) angeschlossen ist,

   **dadurch gekennzeichnet, dass**
   der erste, der zweite und der dritte Versorgungsanschluss (1, 2, 8) der Serienschaltungen (S1, S2) mit einer steuerbaren Spannungsquelle (9), die ein erstes, ein zweites und ein drittes Versorgungspotential (V1, V2, V8) versorgt, verbunden sind.

2. Schaltungsanordnung nach Anspruch 1,
   **dadurch gekennzeichnet, dass**
   die Transistoren (T1, T2; T3, T4) der Serienschaltungen (S1, S2) NMOS-Transistoren sind.

3. Schaltungsanordnung nach Anspruch 2,
   **dadurch gekennzeichnet, dass**
   die NMOS-Transistoren eine isolierte p-dotierte Wanne aufweisen.

4. Schaltungsanordnung nach einem der vorhergehenden Ansprüche,
   **dadurch gekennzeichnet, dass**
   die Teststruktur (10) NMOS-Strukturen aufweist.

5. Schaltungsanordnung nach einem der vorhergehenden Ansprüche,
   **dadurch gekennzeichnet, dass**
   die Teststruktur (10) Metalleiterbahnen aufweist.

6. Schaltungsanordnung nach einem der vorhergehenden Ansprüche,
   **dadurch gekennzeichnet, dass**
   ein weiterer Anschluss (13) der Teststruktur (10) an einem festen Bezugspotential (GND) der integrierten Schaltung angeschlossen ist.

**Claims**

1. Circuit arrangement for measuring the capacitance of structures in an integrated circuit, the integrated circuit comprising a test structure (10) and a reference structure (20),

   - having a first, a second and a third supply terminal (1, 2, 8) for one supply potential (V1, V2, V8) in each case,
   - having a first (S1) and second series circuit (S2), each of which comprises two transistors (T1, T2; T3, T4) which are connected with their controlled paths in series, the first series circuit (S1) being connected between the first and the third supply terminal (1, 8) and the second series circuit (S2) being connected between the second and the third supply terminal (2, 8),
- in which a terminal (11) for the test structure (10) is connected to the coupling node (12) of the transistors (T1, T2) of the first series circuit (S1),
- in which a terminal (21) for the reference structure (20) is connected to the coupling node (22) of the transistors (T3, T4) of the second series circuit (S2),

**characterized in that** the first, the second and the third supply terminal (1, 2, 8) of the series circuits (S1, S2) are connected to a controllable voltage source (9) which supplies a first, a second and a third supply voltage (V1, V2, V8).

**2.** Circuit arrangement according to claim 1, **characterized in that** the transistors (T1, T2; T3, T4) of the series circuits (S1, S2) are NMOS transistors.

**3.** Circuit arrangement according to claim 2, **characterized in that** the NMOS transistors have an insulated p-doped trough.

**4.** Circuit arrangement according to one of the preceding claims, **characterized in that** the test structure (10) has NMOS structures.

**5.** Circuit arrangement according to one of the preceding claims, **characterized in that** the test structure (10) has metal conductor tracks.

**6.** Circuit arrangement according to one of the preceding claims, **characterized in that** a further terminal (13) of the test structure (10) is connected to a fixed reference potential (GND) of the integrated circuit.


**Revendications**

**1.** Montage de mesure de la capacité de structures d'un circuit intégré, le circuit intégré comprenant une structure (10) de test et une structure (20) de référence,

- comprenant une première, une deuxième et une troisième bornes (1, 2, 8) d'alimentation pour respectivement un potentiel (V1, V2, V8) d'alimentation,
- comprenant un premier circuit série (S1) et un deuxième circuit série (S2) qui comprennent respectivement deux transistors (T1, T2, T3, T4) montés en série par leur section commandée, le premier circuit série (S1) étant monté entre la première et la troisième borne (1, 8) d'alimentation et le deuxième circuit série entre la deuxième et la troisième borne (2, 8) d'alimentation,

- dans lequel une borne (11) pour la structure (10) d'essai est relié aux noeuds (12) de couplage des transistors (T1, T2) du premier circuit série (S1),
- dans lequel une borne (21) pour la structure (20) de référence est reliée aux noeuds (22) de couplage des transistors (T3, T4) du deuxième circuit série (S2),

**caractérisé en ce que**
la première, la deuxième et la troisième borne (1, 2, 8) d'alimentation des circuits série (S1, S2) sont reliées à une source (9) de tension, qui peut être commandée et qui donne un premier, un deuxième et un troisième potentiel (V1, V2, V8) d'alimentation.

**2.** Montage suivant la revendication 1,
**caractérisé en ce que**
les transistors (T1, T2, T3, T4) des circuits séries (S1, S2) sont des transistors NMOS.

**3.** Montage suivant la revendication 2,
**caractérisé en ce que**
les transistors NMOS ont une cuvette isolée à dopage du type p.

**4.** Montage suivant l'une des revendications précédentes,
**caractérisé en ce que** la structure (10) de test a des structures NMOS.

**5.** Montage suivant l'une des revendications précédentes,
**caractérisé en ce que**
la structure (10) de test a des pistes conductrices métalliques.

**6.** Montage suivant l'une des revendications précédentes,
**caractérisé en ce que**
une autre borne (13) de la structure (10) de test est reliée à un potentiel (GND) de référence fixe du circuit intégré.

## FIG 1

## FIG 2

# FIG 3